# EUROPÄISCHE PATENTSCHRIFT

(11) **EP 4 012 332 B1**
(45) Veröffentlichungstag und Bekanntmachung des Hinweises auf die Patenterteilung: **13.08.2025**
(21) Anmeldenummer: 21212437.4
(22) Anmeldetag: 06.12.2021
(51) Int. Cl.: G01C 3/04, G01S 17/08, G01S 17/86, G01S 17/88, G01S 7/481, G01S 7/4861, G01S 7/4865

(54) **ENTFERNUNGSMESSER FÜR EIN FERNROHR**
RANGEFINDER FOR A TELESCOPE
TÉLÉMÈTRE POUR UNE LUNETTE DE VISÉE

(30) Priorität: 11.12.2020 AT 510802020
(43) Veröffentlichungstag der Anmeldung: 15.06.2022
(73) Patentinhaber: Swarovski-Optik AG & Co KG., 6067 Absam (AT)
(72) Erfinder: KLINGENSCHMID, Lukas, 6112 Wattens (AT); ZANGERL, Rene, 6060 Hall (AT)
(74) Vertreter: Burger, Hannes

(56) Entgegenhaltungen:
- EP-A1- 2 378 245
- EP-A1- 3 339 901
- US-A1- 2020 077 075

## Beschreibung

Die Erfindung betrifft einen elektrooptischen Entfernungsmesser und ein Verfahren zur Messung der Entfernung eines Objekts mit einem elektrooptischen Entfernungsmesser entsprechend den Oberbegriffen der Ansprüche 1, 15 und 18.

Es sind bereits elektrooptische Entfernungsmesser für die Verwendung bei Freizeitbeschäftigungen oder bei sportlichen Betätigungen bekannt, die als eigenständige Vorrichtung oder integriert in ein Binokular ausgebildet sein können.

Beispielsweise offenbart das Dokument US 2020/077 075 die Überwachung von industriellen Umgebungen, in denen Mensch und Maschine interagieren oder sich nahekommen. Beschrieben werden insbesondere Systeme und Methoden zur Überwachung von Arbeitsbereichen mit Hilfe von 3D-Kameras. Deren Bilder enthalten pixelweise auch Werte der Entfernung der Oberflächenpunkte von Gegenständen in der überwachten Szenerie.

Das Dokument EP 2 378 245 offenbart ein binokulares Beobachtungsgerät bzw. Fernglas mit einem Laser-Entfernungsmesser mit einem Lasersender und einem Laserempfänger und mit zwei visuellen Strahlengängen. Die beiden Beobachtungsstrahlengänge werden jeweils durch ein Objektiv, ein Okular, eine Fokussiereinrichtung und ein Prismen-Umkehrsystem gebildet. Ein Teil des Strahlengangs des Laserempfängers ist in einem der visuellen Strahlengänge integriert.

Das Dokument EP 3 339 901 offenbart eine Distanzmessmethode und ein elektronisches Laserdistanzmessmodul zur schnellen Signalerfassung mit einem Analog-Digital-Wandler. Dabei sollen bei der Signal-Digitalisierung entstehende Umwandlungsfehler mittels Variation der Samplingzeitpunkte kompensiert werden.

Die Aufgabe der vorliegenden Erfindung ist es, einen Entfernungsmesser und ein Verfahren zur Messung der Entfernung eines Objekts zu schaffen, mit dem eine größere Reichweite als auch ein flexiblerer Einsatz ermöglicht wird.

Diese Aufgabe wird durch ein binokulares Fernrohr gemäß den Ansprüchen gelöst.

Das Fernrohr weist allgemein einen elektrooptischen Entfernungsmesser mit einem Sender und einem Sendestrahlengang und mit einem ersten Empfänger und einem ersten Empfängerstrahlengang auf, wobei der erste Empfängerstrahlengang zumindest teilweise in einem ersten Beobachtungsstrahlengang des Fernrohrs verläuft, und wobei ein zweiter Empfänger mit einem zweiten Empfängerstrahlengang, der parallel zu dem Sendestrahlengang ausgerichtet ist, ausgebildet ist, und wobei der zweite Empfängerstrahlengang distanziert von dem ersten Beobachtungsstrahlengang des Fernrohrs angeordnet ist.

Gemäß der Erfindung ist vorgesehen, dass der zweite Empfängerstrahlengang zumindest teilweise in einem zweiten Beobachtungsstrahlengang des Fernrohrs verläuft.

Vorteilhaft ist außerdem, wenn der Sendestrahlengang zumindest teilweise in dem ersten Beobachtungsstrahlengang des Fernrohrs verläuft. Durch diese Maßnahmen kann insgesamt erreicht werden, dass die parallele Ausrichtung der beiden Beobachtungsstrahlengänge, der beiden Empfängerstrahlengänge und des Sendestrahlengangs zuverlässiger aufrechterhalten werden kann. Auch ist bei der Herstellung des Entfernungsmessers dadurch die Justage der Strahlengänge auf deren Parallelität mit einem geringeren Aufwand möglich.

Gemäß der Erfindung in einer ersten Alternative ist weiterhin vorgesehen, dass der Entfernungsmesser eine Auswerteelektronik mit einem Oszillator zur Erzeugung eines Taktsignals, mit einem ersten ADC (Analog-Digital-Konverter) für den ersten Empfänger und mit einem zweiten ADC für den zweiten Empfänger umfasst.

Gemäß dieser Alternative ist der erste ADC zur Erzeugung von digitalen Werten eines von dem ersten Empfänger detektierten, ersten Intensitätsverlaufs reflektierter Strahlung IR1(t1ₙ) zu von dem Taktsignal bestimmten Zeitpunkten t1ₙ ausgebildet, und der zweite ADC ist zur Erzeugung von digitalen Werten eines von dem zweiten Empfänger detektierten, zweiten Intensitätsverlaufs reflektierter Strahlung IR2(t2ₙ) zu von dem Taktsignal bestimmten Zeitpunkten t2ₙ ausgebildet.

Das Merkmal des Entfernungsmessers, wonach die Auswerteelektronik einen Phasenschieber zur Erzeugung einer variablen Zeit-Differenz Δtᵥ zwischen den Zeitpunkten t1ₙ einer Aktivierung des ersten ADC und den Zeitpunkten t2ₙ einer Aktivierung des zweiten ADC umfasst, hat den Vorteil, dass damit die beiden Empfänger synchronisiert und so diese effektiv zu einem einzigen Empfänger zusammengeschaltet werden können.

Von Vorteil ist auch die Weiterbildung, wobei der Phasenschieber eine Phasenregelschleife (Phase-Locked Loop, PLL) umfasst.

Gemäß einer alternativen Ausbildung des Entfernungsmessers ist vorgesehen, dass der Phasenschieber eine Verzögerungsleitung mit einer definierten Leitungslänge umfasst.

Von Vorteil ist außerdem die Ausführungsform des Entfernungsmessers, wobei dieser mit einer Steuervorrichtung mit einem Prozessor, vorzugsweise mit einem FPGA (Field Programable Gate Array) ausgebildet ist. Als Prozessor ist jedes elektronische Bauteil zu sehen, welches programmiert werden und Daten auswerten kann, wie z.B. auch ein ASIC, ein Mikrocontroller, ein Mikroprozessor oder ein Digital-Signal-Prozessor DSP.

In einer vorteilhaften Weiterbildung ist der Entfernungsmesser mit einem mit der Steuervorrichtung in Verbindung stehenden Bedienterminal ausgebildet, wobei das Bedienterminal zur Auswahl von unterschiedlichen Betriebsweisen geeignet ist.

Als vorteilhaft erweist es sich insbesondere, wenn eine erste Betriebsweise, bei der die digitalen Werte der detektierten Strahlungsintensitäten der beiden Empfänger synchronisiert zu einem Summenwert addiert werden, und eine zweite Betriebsweise, bei der die Abtastung der reflektierten Strahlungsintensität durch die beiden Empfänger abwechselnd, um eine halbe Periodendauer T phasenverschoben erfolgt, ausgebildet sind.

Gemäß einer zweiten erfindungsgemäßen Alternative des Entfernungsmessers ist vorgesehen, dass er eine Auswerteelektronik mit einem Oszillator zur Erzeugung eines Taktsignals, mit einem Summierverstärker zur Addition der Messsignale von den beiden Empfängern zu einem Summensignal und mit einem ADC zur Umwandlung des Summensignals umfasst.

Durch die Weiterbildung des Entfernungsmessers, bei der zwischen dem ersten Empfänger und dem Summierverstärker ein Phasenschieber angeordnet ist, kann eine Reduktion von Messfehlern erreicht werden.

Vorteilhaft ist insbesondere die Ausbildung des Entfernungsmessers, bei der der Phasenschieber eine Verzögerungsleitung mit einer definierten Leitungslänge umfasst.

Offenbart wird auch ein Verfahren zur Messung der Entfernung eines Objekts mit einem elektrooptischen Entfernungsmesser, wobei von einem Sender Strahlung emittiert wird und die Strahlung durch einen Sendestrahlengang auf das Objekt gerichtet wird, und wobei von einem ersten Empfänger von dem Objekt reflektierte Strahlung detektiert wird, und wobei ein von dem ersten Empfänger detektierter, zeitlich veränderlicher Intensitätsverlauf der reflektierten Strahlung IR1(t) aufgezeichnet wird, und wobei aus einer Laufzeit der Strahlung von dem Sender zu dem ersten Empfänger die Entfernung des Objekts berechnet wird, und wobei von einem zweiten Empfänger von dem Objekt reflektierte Strahlung detektiert wird und ein vom dem zweiten Empfänger detektierter, zeitlich veränderlicher Intensitätsverlauf der reflektierten Strahlung IR2(t) aufgezeichnet wird. Durch einen ersten ADC werden zu von einem Taktsignal bestimmten Zeitpunkten t1ₙ aus dem ersten Intensitätsverlauf IR1(t) digitale Werte des ersten Intensitätsverlaufs IR1(t1ₙ) erzeugt. Und durch einen zweiten ADC werden zu von dem Taktsignal bestimmten Zeitpunkten t2ₙ aus dem zweiten Intensitätsverlauf IR2(t) digitale Werte des zweiten Intensitätsverlaufs IR2(t2ₙ) erzeugt, wobei die Zeitpunkte t2ₙ gegenüber den Zeitpunkten t1ₙ um eine Zeit-Differenz Δt phasenverschoben sind, also t2 = t1 + Δt, wobei sich die Zeit-Differenz Δt zusammensetzt aus einem System-bedingten Anteil Δtₛ und einem variablen Anteil Δtᵥ und somit gilt Δt = Δtₛ + Δtᵥ. Die Anteile Δtₛ und Δtᵥ sowie Δt können dabei sowohl positive als auch negative Werte annehmen.

Vorteilhaft ist insbesondere die Verfahrensweise, wonach ein Wert der variablen Zeit-Differenz Δtᵥ so groß gewählt wird, dass die Zeitpunkte t1ₙ und t2ₙ jeweils einem gleichen Zeitpunkt der Intensitätsverläufe der reflektierten Strahlung IR1(t), IR2(t) an dem ersten Empfänger und an dem zweiten Empfänger entsprechen, und dass anschließend die Werte des ersten Intensitätsverlaufs IR1(t1ₙ) und die Werte des zweiten Intensitätsverlaufs IR2(t2ₙ) = IR2(t1ₙ) jeweils miteinander addiert werden.

Gemäß einer alternativen Verfahrensweise wird ein Wert der variablen Zeit-Differenz Δtᵥ so groß gewählt, dass die Zeitpunkte t1ₙ und t2ₙ jeweils Zeitpunkten der Intensitätsverläufe der reflektierten Strahlung IR1(t), IR2(t) an dem ersten Empfänger und an dem zweiten Empfänger entsprechen, die um den Wert einer halben Periodendauer T des Taktsignals zueinander phasenverschoben sind. Anschließend wird aus den Werten des ersten Intensitätsverlaufs IR1(t1ₙ) und aus den Werten des zweiten Intensitätsverlaufs IR2(t2ₙ) ein Gesamt-Intensitätsverlauf IR(tₙ) mit doppelter zeitlicher Auflösung, in der Form IR1(t1ₙ), IR2(t1ₙ+T/2), IR1(t1ₙ₊₁), IR2(t1ₙ₊₁+T/2), IR1(t1ₙ₊₂), IR2(t1₁₊₂+T/2), u.s.w., gebildet.

Offenbart wird schließlich ein Verfahren zur Messung der Entfernung eines Objekts mit einem elektrooptischen Entfernungsmesser gelöst, wobei von einem Sender Strahlung emittiert wird und die Strahlung durch einen Sendestrahlengang auf das Objekt gerichtet wird, und wobei von einem ersten Empfänger von dem Objekt reflektierte Strahlung detektiert wird, und wobei ein von dem ersten Empfänger detektierter, zeitlich veränderlicher Intensitätsverlauf der reflektierten Strahlung IR1(t) aufgezeichnet wird, und wobei aus einer Laufzeit der Strahlung von dem Sender zu dem ersten Empfänger die Entfernung des Objekts berechnet wird. Dabei wird von einem zweiten Empfänger von dem Objekt reflektierte Strahlung detektiert und ein vom dem zweiten Empfänger detektierter, zeitlich veränderlicher Intensitätsverlauf der reflektierten Strahlung IR2(t) wird aufgezeichnet, wobei Messsignale von dem ersten Empfänger durch einen Phasenschieber um eine variable Zeit-Differenz Δtᵥ relativ zu Messsignalen von dem zweiten Empfänger phasenverschoben werden.

Vorteilhaft ist insbesondere die Verfahrensweise, bei der ein Wert der variablen Zeit-Differenz Δtᵥ so groß gewählt wird, dass den Messsignalen IR1(t) und IR2(t) entsprechende Zeitpunkte jeweils einem gleichen Zeitpunkt der Intensitätsverläufe der reflektierten Strahlung IR1(t), IR2(t) an dem ersten Empfänger und an dem zweiten Empfänger entsprechen, und dass anschließend die Messsignale der Intensitätsverläufe der reflektierten Strahlung IR1(t) und IR2(t) durch einen Summierverstärker zu einem Summensignal addiert werden.

Zum besseren Verständnis der Erfindung wird diese anhand der nachfolgenden Figuren näher erläutert.

Es zeigen jeweils in stark vereinfachter, schematischer Darstellung:
- Fig. 1: einen elektrooptischen Entfernungsmesser in Form eines Binokulars;
- Fig. 2: ein vereinfachtes Schaltbild der Steuer- und Auswerteeinheit des Entfernungsmessers gemäß Fig. 1;
- Fig. 3: eine schematische Darstellung des Funktionsprinzips der elektrooptischen Entfernungsmessung;
- Fig. 4: ein Diagramm des Strahlungsintensität-Verlaufs des emittierten Laserpulses und des reflektierten Strahlungsimpulses;
- Fig. 5: einen vergrößerten Ausschnitt des Intensitätsverlaufs des reflektierten Strahlungsimpulses, gemäß Fig. 4;
- Fig. 6: eine schematische Darstellung der digitalen Messwerte gemäß der ersten Betriebsweise des Entfernungsmessers;
- Fig. 7: einen Ausschnitt des Intensitätsverlaufs des reflektierten Strahlungsimpulses, gemäß Fig. 4, bei doppelter Abtastrate;
- Fig. 8: eine schematische Darstellung der digitalen Messwerte bei der Betriebsweise mit doppelter Abtastrate, gemäß Fig. 7;
- Fig. 9: ein alternatives Ausführungsbeispiel des Entfernungsmessers;
- Fig. 10: ein alternatives Ausführungsbeispiel der Steuer- und Auswerteeinheit des Entfernungsmessers;
- Fig. 11: eine vereinfachte Darstellung der Steuer- und Auswerteeinheit des Entfernungsmessers, gemäß Fig. 2.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

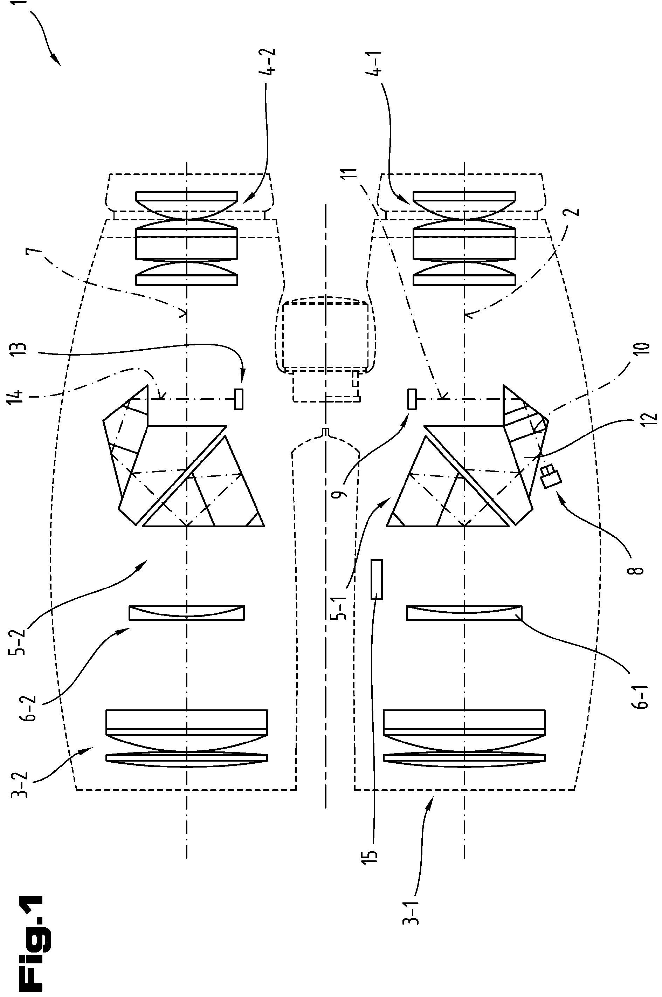

Die Fig. 1 zeigt einen elektrooptischen Entfernungsmesser 1 in Form eines Binokulars. Dieses weist in einem ersten Tubus einen ersten Beobachtungsstrahlengang 2, der sich zwischen einem Objektiv 3-1 und einem Okular 4-1 erstreckt, auf. Im Verlauf des Beobachtungsstrahlengangs 2 ist weiters - in an sich bekannter Weise - ein durch ein Prismensystem gebildetes Umkehrsystem 5-1 und eine Fokussierlinse 6-1 angeordnet. Parallel zu dem ersten Beobachtungsstrahlengang 2 ist ein in analoger Weise gebildeter, zweiter Beobachtungsstrahlengang 7 vorgesehen.

Der elektrooptische Entfernungsmesser 1 umfasst einen Sender 8 und einen ersten Empfänger 9, wobei ein Sendestrahlengang 10 des Senders 8 als auch ein erster Empfängerstrahlengang 11 des ersten Empfängers 9 zumindest teilweise in dem ersten Beobachtungsstrahlengang 2 verlaufen. Dazu wird in an sich bekannter Weise von dem Sender 8 emittierte Strahlung mit Hilfe eines Teilerprismas 12 an einer Grenzfläche des Umkehrsystems 5-1 in den ersten Beobachtungsstrahlengang 2 eingekoppelt. Dies erfolgt derart, dass die Strahlung durch das Objektiv 3-1 auf ein entferntes Objekt hin ausgestrahlt wird. In umgekehrter Richtung gelangt dann von dem entfernten Gegenstand reflektierte Strahlung durch das Objektiv 3-1 in den ersten Beobachtungsstrahlengang 2 und wird an einer Grenzfläche des Umkehrsystems 5-1 aus dem ersten Beobachtungsstrahlengang 2 ausgekoppelt. Die Strahlung gelangt schließlich durch den ersten Empfängerstrahlengang 11 zu dem Empfänger 9, von dem die Strahlung detektiert wird.

Gemäß diesem Ausführungsbeispiel weist das Binokular bzw. der Entfernungsmesser 1 zusätzlich auch noch einen zweiten Empfänger 13 auf, der in dem zweiten Tubus des Binokulars angeordnet ist und mit dem zweiten Beobachtungsstrahlengang 7 gekoppelt ist. Dabei gelangt in gleicher Weise wie beim ersten Beobachtungsstrahlengang 2 von einem entfernten Objekt reflektierte Strahlung durch einen zweiten Empfängerstrahlengang 14 zu dem zweiten Empfänger 13, wobei die Strahlung zunächst durch das Objektiv 3-2 des zweiten Tubus in den zweiten Beobachtungsstrahlengang 7 des Binokulars eintritt. Dabei wird die reflektierte Strahlung an einer Grenzfläche des Umkehrsystems 5-2 aus dem zweiten Beobachtungsstrahlengang 7 ausgekoppelt.

Zu der Ansteuerung des Senders 8 als auch zur Erfassung der Messsignale von den beiden Empfängern 9, 13 umfasst der Entfernungsmesser 1 eine Steuer- und Auswerteeinheit 15.

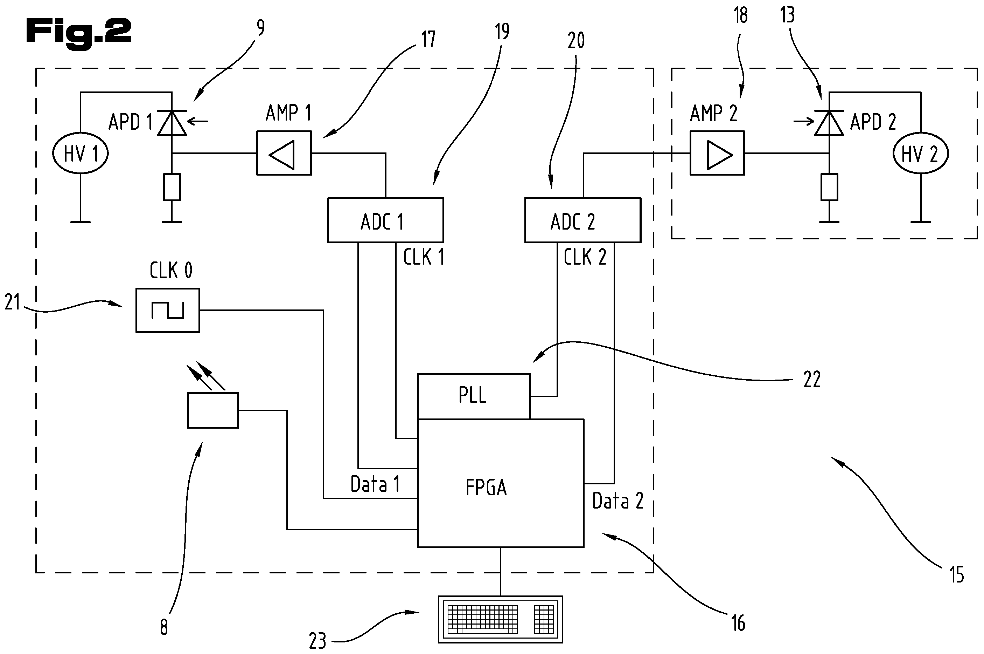

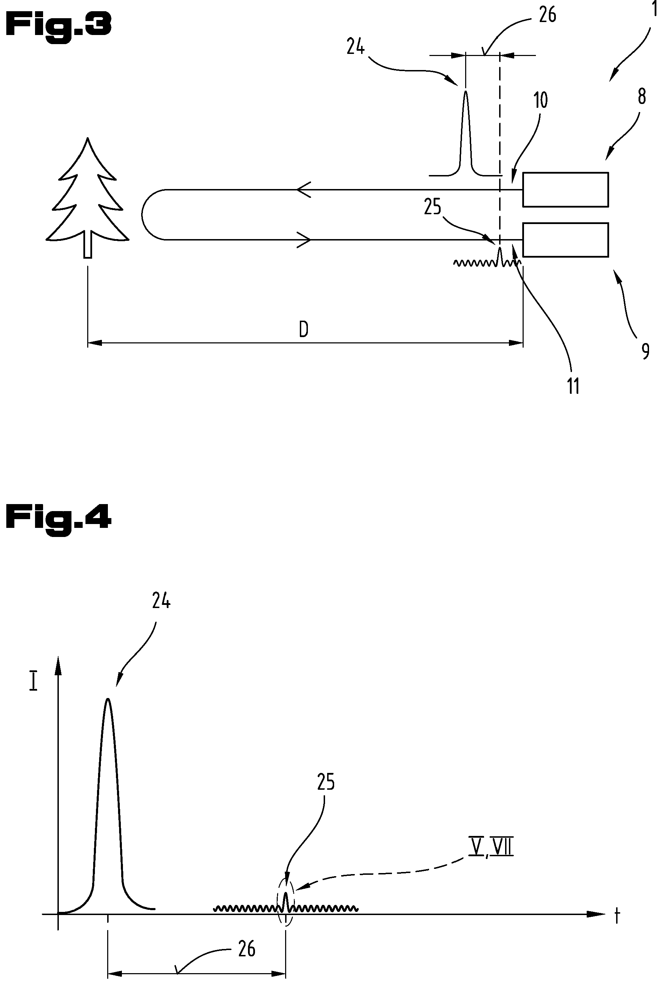

Die Fig. 2 zeigt die Steuer- und Auswerteeinheit 15 des Entfernungsmessers 1 gemäß Fig. 1, dargestellt als vereinfachtes Schaltbild. Zum Messen der Entfernung eines entfernten Gegenstands wird von der Steuer- und Auswerteeinheit 15 des Entfernungsmessers 1 die Aussendung von Strahlung von dem Sender 8 in Richtung auf den entfernten Gegenstand veranlasst. Aus der Differenz der Zeiten der Emission der Strahlung und dem Eintreffen der von dem entfernten Gegenstand reflektierten Strahlung bei den Empfängern 9, 13 wird sodann die Entfernung berechnet (Fig.3, 4). Dazu umfasst die Steuer- und Auswerteeinheit 15 eine Steuervorrichtung 16, mit der der Ablauf der Messung gesteuert und die Auswertung durchgeführt wird. Das Auslösen eines solchen Messvorgangs erfolgt auf Veranlassung eines Benutzers der dazu den zu vermessenden Gegenstand mit dem Binokular bzw. mit dem Entfernungsmesser 1 anvisiert und durch Bestätigen eines entsprechenden Schalters die Messung startet.

Gemäß diesem Ausführungsbeispiel des elektrooptischen Entfernungsmessers 1 wird der Sender 8 durch einen Laser gebildet. Die Aussendung der Strahlung von dem Sender 8 erfolgt dabei in der Form von kurzen Laserpulsen 24 (Fig.3, 4). Als Empfänger 9, 13 sind Lawinenfotodioden vorgesehen. Von diesen Empfängern 9, 13 detektierte Intensitätsverläufe der reflektierten Strahlung werden nach entsprechender Verstärkung (mit Verstärkern 17, 18) als analoge Messsignale einer digitalen Auswertung durch die Steuervorrichtung 16 zugeführt. Die von den Empfängern 9, 13 detektierte Strahlung enthält dabei neben der reflektierten Strahlung der ausgesendeten Laserpulse naturgemäß aber auch Anteile von Umgebungslicht (reflektierter Strahlungsimpuls 25, Fig. 4), welche einen großen Rauschanteil verursachen und eine Auswertung erschweren. Mit Hilfe eines ersten ADC 19 und eines zweiten ADC 20 (ADC ... Analog-Digital-Konverter) werden die analogen Messsignale der Intensitätsverläufe von den Empfängern 9, 13 in digitale Werte bzw. digitale Messdaten umgewandelt. Dazu umfasst die Steuer- und Auswerteeinheit 15 des Entfernungsmessers 1 einen Oszillator 21 zur Erzeugung eines Taktsignals. Durch dieses Taktsignal des Oszillators 21 werden diskrete Zeitpunkte bestimmt, zu denen eine Abtastung der analogen Messsignale der Empfänger 9, 13 mit Hilfe des ersten ADC 19 und des zweiten ADC 20 erfolgt.

Durch die zusätzliche Verwendung des zweiten Empfängers 13 in dem zweiten Tubus des Binokulars bzw. des Entfernungsmessers 1 kann grundsätzlich der Vorteil einer etwa doppelt so großen, effektiven Empfangsfläche der Empfänger 9, 13 erzielt werden, in dem deren Messsignale der reflektierten Strahlung addiert werden. Bei gleicher Leistung des Senders 8 kann dadurch eine entsprechende Steigerung der maximalen Reichweite des Entfernungsmessers 1 erzielt werden. Hinsichtlich der Möglichkeit digitale Messdaten von den beiden Analogdigitalkonvertern (erster ADC 19, zweiter ADC 20) in korrekter Weise addieren zu können, sind mögliche Unterschiede in den Signallaufzeiten zu den beiden Analogdigitalkonvertern hin zu beachten. Solche Unterschiede können beispielsweise von unterschiedlichen Leitungslängen zwischen den Empfängern 9, 13 und den jeweiligen Analogdigitalkonvertern ADC 19, 20 in der Steuervorrichtung 16 her rühren. Zu berücksichtigen sind aber auch mögliche Unterschiede in den konkreten elektronischen Bauteilen selbst, wie den Lawinenfotodioden der Empfänger 9, 13 als auch den Verstärkern 17, 18, die bauartbedingt unterschiedliche zeitliche Verzögerungen aufweisen können. Das bedeutet, dass ein von dem ersten ADC 19 zu einem von dem Taktsignal des Oszillators 21 vorgegebenen Zeitpunkt t1ₙ erzeugter digitaler Wert der Intensität der reflektierten Strahlung IR1(t1ₙ) tatsächlich einem der Signallaufzeit und/oder durch unterschiedliche Verzögerungen in den elektronischen Bauteilen entsprechenden früheren Zeitpunkt entspricht (ergibt in Summe eine System-bedingte Verzögerung Δtₛ) und diesem früheren Zeitpunkt zuzuordnen ist. Dies trifft in gleicher Weise auch für einen von dem zweiten ADC 20 erzeugten digitalen Wert der Intensität der reflektierten Strahlung IR2(t2ₙ) zu.

Bei dem elektrooptischen Entfernungsmesser 1 ist erfindungsgemäß vorgesehen, dass die Steuervorrichtung 16 einen Phasenschieber 22 zur Erzeugung einer variablen Zeit-Differenz Δtᵥ zwischen den Zeitpunkten t1ₙ einer Aktivierung des ersten ADC 19 und den Zeitpunkten t2ₙ einer Aktivierung des zweiten ADC 20 umfasst. Auf diese Weise kann erreicht werden, dass digitale Werte des ersten ADC 19 und des zweiten ADC 20 jeweils miteinander zu einem Summenwert addiert werden, die von dem ersten Empfänger 9 und dem zweiten Empfänger 13 detektierten Intensitäten der reflektierten Strahlung zu jeweils dem gleichen Zeitpunkt entsprechen.

Die Verwendung des Phasenschiebers 22 zur Erzeugung der variablen Zeit-Differenz Δtᵥ bewirkt insofern eine Synchronisierung der von dem ersten Empfänger 9 und dem zweiten Empfänger 13 erhaltenen digitalen Messsignale. Solcherart wird also erreicht, dass nicht fälschlicherweise Werte von Strahlungsintensitäten zu einem Summenwert miteinander addiert werden, die zu voneinander verschiedenen Zeitpunkten von dem ersten Empfänger 9 und dem zweiten Empfänger 13 detektiert worden sind. Erst dadurch kommt den beiden Empfängern 9, 13 effektiv die Wirkung eines einzigen Empfängers mit einer in etwa doppelt so großen Empfangsfläche zu.

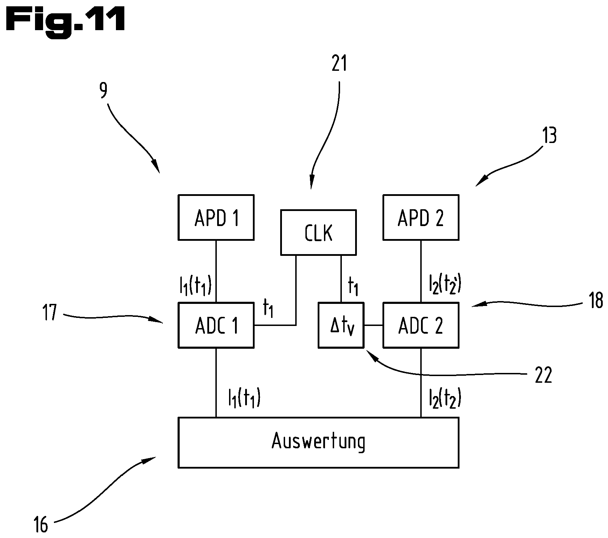

Zur Verdeutlichung dessen wird auf die Fig. 11 Bezug genommen, wo den Bauteilen der Steuer- und Auswerteeinheit 16 des Entfernungsmessers 1 (Fig. 2) entsprechende Zeitpunkte bzw. Intensitäten beigestellt sind. Unter der Verwendung der Bezeichnungsweise Δtᵥ für die durch den Phasenschieber 22 erzeugte variable Zeit-Differenz und Δtₛ für die System-bedingte zeitliche Verzögerung lassen sich die Zusammenhänge folgendermaßen beschreiben. Sollen die Intensitäten IR1(t1) und IR2(t2) in korrekter Weise miteinander addiert werden können, so sollen sie zu einem gleichen Zeitpunkt von den Empfängern 9, 13 detektiert worden sein, d.h. t2 = t1. Aufgrund der System-bedingten zeitlichen Verzögerung Δtₛ ergäbe sich nun aber für den zweiten Empfänger 13 eine Intensität IR2(t2') zu einem anderen Zeitpunkt t2' = t1 + Δtₛ. Unter Berücksichtigung der durch den Phasenschieber 22 erzeugten variablen Zeit-Differenz Δtᵥ ergibt sich der Wert des Zeitpunkts t2 zu t2 = t2' + Δtᵥ. Daraus ergibt sich weiters t2 = t2' + Δtᵥ = t1 + Δtₛ + Δtᵥ.

Ausgehend von dieser Beziehung muss also zur Erfüllung der Bedingung t2 = t1 gelten, dass Δtᵥ= -Δtₛ. Womit der Sachverhalt zum Ausdruck gebracht wird, dass die System-bedingte zeitliche Verzögerung Δtₛ durch die vom Phasenschieber 22 erzeugte variable Zeit-Differenz Δtᵥ kompensiert und somit Δt = 0 wird.

Gemäß einer bevorzugten Ausführungsform des elektrooptischen Entfernungsmessers 1 umfasst die Steuervorrichtung 16 ein sogenanntes FPGA (Field Programable Gate Array). Von dem FPGA kann neben der Steuerung auch die Auswertung der Messsignale, bis hin zur Berechnung und Anzeige der Entfernung ausgeführt werden. Als Phasenschieber 22 wird vorzugsweise eine sogenannte Phase-Locked-Loop (PLL) verwendet. Der Phasenschieber 22 kann alternativ auch durch einen digitalen PLL, abgekürzt DPLL, ausgebildet sein. Dabei ist es auch möglich, dass der PLL von dem FPGA umfasst ist. Gemäß einer alternativen Ausführungsform umfasst der Phasenschieber 22 eine Verzögerungsleitung.

Mit dem den ersten Empfänger 9 und den zweiten Empfänger 13 umfassenden elektrooptischen Entfernungsmesser 1 erfolgt die Messung der Entfernung eines entfernten Objekts in der Weise, dass durch den ersten ADC 19 zu von dem Taktsignal des Oszillators 21 bestimmten Zeitpunkten t1ₙ aus dem ersten Intensitätsverlauf IR1(t) digitale Werte des ersten Intensitätsverlaufs IR1(t1ₙ) erzeugt werden und durch den zweiten ADC 20 zu von dem Taktsignal bestimmten Zeitpunkten t2ₙ aus dem zweiten Intensitätsverlauf IR2(t) digitale Werte des zweiten Intensitätsverlaufs IR2(t2ₙ) erzeugt werden, wobei die Zeitpunkte t1ₙ gegenüber den Zeitpunkten t2ₙ um eine Zeit-Differenz Δt phasenverschoben sind, wobei sich die Zeit-Differenz Δt zusammensetzt aus einem System-bedingten Anteil Δtₛ und einem variablen Anteil Δtᵥ. Die Werte des ersten Intensitätsverlaufs IR1(t1ₙ) und die Werte des zweiten Intensitätsverlaufs IR2(t2ₙ) werden von der Steuervorrichtung 16 aufgezeichnet und anschließend jeweils zu einem Summenwert addiert. Die so erhaltenen Digitaldaten des zeitlich veränderlichen Intensitätsverlaufs der reflektierten Strahlung von den Empfängern 9, 13 bilden sodann die Grundlage zur Berechnung der Entfernung aus der Laufzeit der Strahlung von dem Sender 8 zu den Empfängern 9, 13. Die Aufzeichnung und Weiterverarbeitung der digitalen Messdaten und die anschließende Berechnung der Entfernung aus diesen Messdaten wird durch die Steuervorrichtung 16 auf Basis entsprechender, in der Steuervorrichtung 16 gespeicherter Programme durchgeführt.

Bei der beschriebenen Verfahrensweise gemäß der ersten Ausführungsform werden Digitaldaten der detektierten Strahlungsintensität zu jeweils gleichen Zeitpunkten zu einem Summenwert addiert. Die auch als digitaler Signalvektor bezeichnete zeitliche Abfolge von Strahlungsintensitätswerten IR1(t1₂), IR1(t1ₙ₊₁), IR1(t1ₙ₊₂), ... hat eine zeitliche Auflösung entsprechend einer Periodendauer T des Taktsignals des Oszillators 21. Dies trifft analog auch auf die zeitliche Abfolge der Strahlungsintensitätswerte IR2(t2ₙ), IR2(t2ₙ₊₁), IR2(t2ₙ₊₂), ... des zweiten ADC 20 zu. Dieselbe zeitliche Auflösung hat auch die Folge der jeweils miteinander addierten Intensitätswerte des summierten digitalen Signalvektors IR1(t1₁) + IR2(t1ₙ), IR1(t1ₙ₊₁) + IR2(t1ₙ₊₁), IR1(t1ₙ₊₂) + IR2(t1ₙ₊₂), u.s.w.

Gemäß einem alternativen Ausführungsbeispiel des elektrooptischen Entfernungsmessers 1 ist vorgesehen, dass bei der Erzeugung der digitalen Werte des Intensitätsverlaufs der reflektierten Strahlung durch den ersten ADC 19 und durch den zweiten ADC 20 eine zusätzliche Phasenverschiebung der Länge einer halben Periodendauer T des Taktsignals des Oszillators 21 vorgesehen ist. Im Unterschied zu dem zuerst beschriebenen Ausführungsbeispiel des Verfahrens erfolgt dabei keine Addition von Digitaldaten des ersten ADC 19 und des zweiten ADC 20. Stattdessen wird von der Steuervorrichtung 16 aus den digitalen Signalvektoren des ersten ADC 19 und des zweiten ADC 20 ein digitaler Signalvektor mit der doppelten zeitlichen Auflösung gebildet. Das heißt die Zeitpunkte der Abtastung der digitalen Werte der Strahlungsintensitäten durch den ersten ADC 19 und durch den zweiten ADC 20 werden durch den Phasenschieber ineinander verschachtelt, sodass ein digitaler Signalvektor in der Form IR1(t1ₙ), IR2(t1ₙ+T/2), IR1(t1ₙ₊₁), IR2(t1ₙ₊₁+T/2), IR1(t1ₙ₊₂), IR2(t1ₙ₊₂+T/2), ... gebildet wird. Dieser enthält somit eine Abfolge von digitalen Werten der detektierten Strahlungsintensität des ersten Empfängers 9 und des zweiten Empfängers 13, wobei Werte des ersten ADC 19 und des zweiten ADC 20 abwechselnd aufeinander folgen. Auf diese Weise wird der zeitliche Intensitätsverlauf der reflektierten Strahlung effektiv mit einer doppelt so hohen Abtastrate aufgezeichnet als der Frequenz des Taktsignals des Oszillators 21 entspricht. Auf der Grundlage des so erzeugten, digitalen Signalvektors doppelter Abtastrate wird von der Steuervorrichtung 16 anschließend der Wert der Entfernung berechnet.

Wiederum unter Berücksichtigung der symbolischen Darstellung von Fig. 11 lassen sich die formalen Beziehungen folgendermaßen ausdrücken. Die von den beiden Empfängern 9, 13 detektierten Intensitäten IR1(t1) und IR2(t2) sollen zu Zeitpunkten t1 und t2 erfasst worden sein, die sich um die Länge einer halben Periodendauer T des Taktsignals des Oszillators 21 voneinander unterscheiden, d.h. t2 = t1 + T/2, also Δt = T/2. Unter Berücksichtigung der System-bedingten zeitlichen Verzögerung Δtₛ und der durch den Phasenschieber 22 erzeugten variablen Zeit-Differenz Δtᵥ, wie bereits bei der Beschreibung der ersten Betriebsweise berücksichtigt, erhält man in diesem Fall t2 = t1 + Δtₛ + Δtᵥ = t1 + T/2.

Daraus ergibt sich als Wert für die von dem Phasenschieber 22 zu erzeugende variable Zeit-Differenz Δtᵥ = T/2 - Δtₛ.

Gemäß einer bevorzugten Ausführungsführungsvariante des elektrooptischen Entfernungsmessers 1 ist dieser zur wahlweisen Ausführung unterschiedlicher Betriebsweisen ausgebildet. Dazu weist der Entfernungsmesser 1 eine Tastatur bzw. ein Bedienterminal 23 auf, das mit der Steuervorrichtung 16 in Verbindung steht. Ein Benutzer des Entfernungsmessers 1 hat so die Möglichkeit, den Entfernungsmesser 1 zwischen unterschiedlichen Betriebsweisen hin und her zu schalten, indem er durch Auswahl über die Tastatur 23 die Ausführung eines entsprechenden Programms durch die Steuervorrichtung 16 bestimmt. Neben den bereits vorstehend beschriebenen Betriebsweisen des Entfernungsmessers 1, nämlich derjenigen, bei der die digitalen Werte der detektierten Strahlungsintensitäten der beiden Empfänger 9, 13 zu einem Summenwert addiert werden und andererseits derjenigen Betriebsweise, bei der die Abtastung der reflektierten Strahlungsintensität um eine halbe Periodendauer T phasenverschoben abwechselnd erfolgt, besteht auch die Möglichkeit, die Entfernungsmessung nur unter Verwendung des zweiten Empfängers 13 in dem zweiten Beobachtungsstrahlengang 7 durchzuführen. Das heißt, dass in dieser dritten Betriebsweise des Entfernungsmessers 1 der erste Empfänger 9 in dem ersten Beobachtungsstrahlengang 2 außer Betrieb gesetzt ist und nicht verwendet wird. Diese dritte Betriebsweise des Entfernungsmessers 1 erweist sich insbesondere bei der Entfernungsmessung von Objekten in relativ geringer Distanz als vorteilhaft. Sogenannte optische Übersprecher, wie sie zwischen dem Sender 8 und dem ersten Empfänger 9, die sich in demselben, ersten Beobachtungsstrahlengang 2 befinden, auftreten können, werden dadurch vermieden, wodurch Fehlmessungen leichter verhindert werden können.

Für die beschriebene elektrooptische Entfernungsmessung wird vorzugsweise eine Vielzahl von Laserpulsen von dem Sender 8 ausgesendet. Dieses Aussenden der Laserpulse erfolgt mit einer hohen Frequenz von beispielweise 56 kHz. Durch das Aufsummieren der reflektierten Strahlung vieler Einzelimpulse, wie zum Beispiel über 1024 Einzelmessungen, wird die Qualität des Messignals deutlich verbessert und eine Auswertung erleichtert. Die Auswertung erfolgt dabei wie bei der Messung mit einem Einzelimpuls, aber nach der Aufsummierung und angewandt auf das Summensignal.

Bei den beschriebenen Ausführungsbeispielen ist ein Wert der Frequenz des Oszillators 21 von vorzugsweise 80 MHz vorgesehen. Dieser Frequenz entsprechend erfolgt die Abtastung der reflektierten Strahlung bzw. der Laserpulse mit einer zeitlichen Auflösung von T = 12,5 ns.

Anhand der Fig. 3 und 4 wird das grundsätzliche Funktionsprinzip der elektrooptischen Entfernungsmessung kurz illustriert. Ein in einer Entfernung D befindlicher Gegenstand (Baum) wird durch den Entfernungsmesser 1 vermessen, indem durch den Sender 8 ein Laserpuls 24 durch den Sendestrahlengang 10 auf den Gegenstand hin ausgesendet wird. Ein von diesem zurückgeworfener, reflektierter Strahlungsimpuls 25 gelangt sodann über den Empfängerstrahlengang 11 wieder in den Entfernungsmesser 1 und wird von dem Empfänger 9 detektiert. Durch die Zeitpunkte des Aussendens des Laserpulses 24 und des Empfangens des reflektierten Strahlungsimpulses 25 ist eine Impulslaufzeit 26 bestimmt, deren Produkt mit der Lichtgeschwindigkeit bekanntlich gleich ist dem doppelten des Wertes der Entfernung D des zu vermessenden Gegenstandes.

Die Fig. 4 zeigt ein Diagramm des zeitlichen Verlaufs der Strahlungsintensität des emittierten Laserpulses 24 und des reflektierten Strahlungsimpulses 25 in deren zeitlichen Verhältnis zueinander. Wie durch die Darstellung des reflektierten Strahlungsimpulses 25 in der Fig. 4 symbolisch angedeutet, enthält dieser neben einem Anteil der Strahlung des reflektierten Laserpulses 24 zusätzlich auch noch von der natürlichen Umgebungsstrahlung stammende Anteile als Störsignal. Als Ende der Impulslaufzeit 26 wird daher auf einen Zeitpunkt im Bereich des Maximums der Intensität des reflektierten Strahlungsimpulses 25 Bezug genommen. Dieser relativ hohe Anteil von Störsignalen in dem Intensitätsverlauf der reflektierten Strahlungsimpulse 25 macht es erforderlich, die Messung der reflektierten Strahlung mit einer Vielzahl von Laserpulsen 24 zu wiederholen. Durch ein entsprechendes Summieren über viele Einzelmessungen kann das Rauschen bzw. der Störsignalanteil reduziert werden. Anders ausgedrückt: Das Signal-Rausch-Verhältnis (bzw. Signal Noise Ratio - SNR) im gemessenen Intensitätsverlauf wird dadurch wesentlich erhöht.

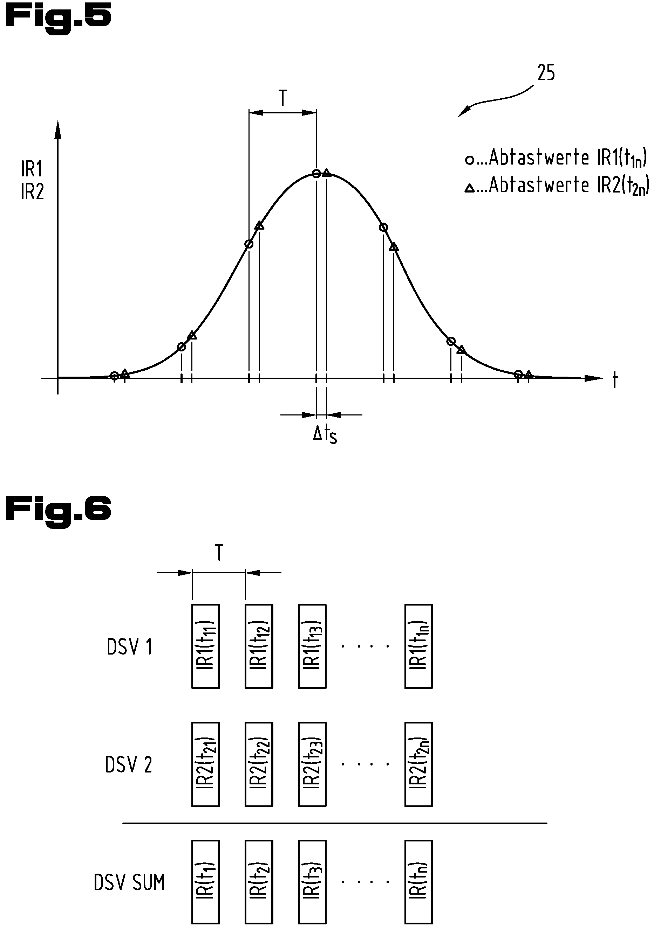

Die Fig. 5 zeigt einen stark vergrößerten Ausschnitt des Intensitätsverlaufs des reflektierten Strahlungsimpulses 25 im Bereich des Maximus seines Intensitätsverlaufs, gemäß Fig. 4. Auf dem Kurvenverlauf des reflektierten Strahlungsimpulses 25 sind dabei Punkte durch Symbole hervorgehoben, wie sie einer Messung durch Abtastungen mit den Analogdigitalkonvertern ADC 19 und ADC 20 entsprechen. Zwischen Messpunkten des ersten ADC 19 (Symbol: Kreis) und Messpunkten des zweiten ADC 20 (Symbol: Dreieck) liegt dabei ein zeitlicher Abstand im Ausmaß der Zeit-Differenz Δtₛ. Diese Zeit-Differenz Δtₛ entspricht dem im Zusammenhang mit der Beschreibung der Fig. 2 erwähnten System-bedingten Unterschied in den Signallaufzeiten zwischen den beiden Empfängern 9, 13 und den jeweiligen Analogdigitalkonvertern ADC 19, 20 des Entfernungsmessers 1. Im Falle der Anwendung der ersten Betriebsweise des Entfernungsmessers 1 erzeugt der Phasenschieber 22 eine entsprechend große Zeit-Differenz Δtᵥ, durch die erreicht wird, dass digitale Werte des ersten ADC 19 und des zweiten ADC 20 jeweils miteinander zu einem Summenwert addiert werden können, die von dem ersten Empfänger 9 und dem zweiten Empfänger 13 detektierten Intensitäten der reflektierten Strahlung zu jeweils dem gleichen Zeitpunkt entsprechen. Durch den Phasenschieber 22 werden die in Fig. 5 gezeigten zeitlichen Abstände insofern auf Null reduziert. Im Übrigen kann eine Zeit-Differenz Δt auch in Beziehung gesetzt werden zu der Periodendauer T des Taktsignals des Oszillators 21, wobei eine volle Phasendauer bzw. die Periodendauer T dem Vollwinkel von 360° entspricht. Eine Korrektur mit dem Phasenschieber 22 wird vorzugsweise dann durchgeführt, wenn die der Zeit-Differenz Δtₛ entsprechende Phasenverschiebung größer ist als 10°, bevorzugt wenn sie größer ist als 15°. Im Falle einer Phasenverschiebung kleiner als 20° kann auf eine Kompensation auch verzichtet werden.

Die Fig. 6 zeigt eine schematische Darstellung der digitalen Messwerte des reflektierten Strahlungsimpulses 25 in der Betriebsweise des Entfernungsmessers 1, bei der die digitalen Werte der detektierten Strahlungsintensitäten der beiden Empfänger 9, 13 jeweils zu einem Summenwert addiert werden. Dabei ist bei der Abtastung durch die Analogdigitalkonverter ADC 19 und ADC 20 die Erzeugung der Zeit-Differenz Δtᵥ durch den Phasenschieber 22 berücksichtigt (Fig. 2). In der tabellarischen Darstellung gemäß Fig. 6 symbolisiert die erste Zeile "DSV 1" den digitalen Signalvektor des ersten ADC 19 mit den digitalisierten Strahlungsintensitätswerten IR1(t₁₁), IR1(t₁₂), IR1(t₁₃), .... und die zweite Zeile "DSV 2" den Signalvektor des zweiten ADC 20 mit den Strahlungsintensitätswerten IR2(t₂₁), IR2(t₂₂), IR2(t₂₃), .... Schließlich ist in der dritten Zeile "DSV SUM" der summierte digitale Signalvektor mit den Werten IR(t₁), IR(t₂), IR(t₃), .... dargestellt. Der zeitliche Abstand innerhalb der jeweiligen Zeilen, von Messwert zu Messwert, entspricht dem Taktsignal des Oszillators 21, das heißt der Periodendauer T.

Wie in Fig. 6 dargestellt, werden in gleicher Weise gemessene und digitalisierte Intensitätsverläufe vieler einzelner und nacheinander folgender Pulsantworten vor der Bestimmung der Impulslaufzeit 26 zu einem Summensignalvektor aufsummiert, um das Rauschen auszumitteln und das SNR zu erhöhen.

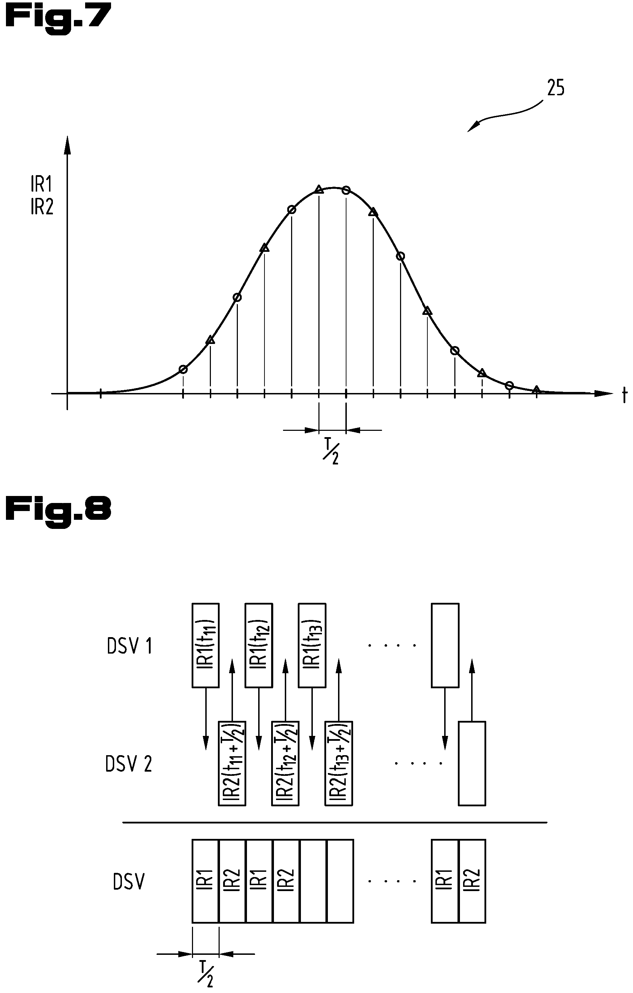

Die Fig. 7 zeigt einen Ausschnitt des Intensitätsverlaufs des reflektierten Strahlungsimpulses 25, gemäß Fig. 4, zur Illustration der Betriebsweise des Entfernungsmessers 1, bei der die Abtastung der reflektierten Strahlungsimpulse 25 mit dem ersten ADC 19 und dem zweiten ADC 20 jeweils um eine halbe Periodendauer T phasenverschoben, abwechselnd erfolgt. Bei dieser Betriebsweise (gemäß dem zweiten Ausführungsbeispiel des elektrooptischen Entfernungsmessers 1) liegen also zwischen Zeitpunkten der Abtastung der digitalen Werte der Strahlungsintensitäten des reflektierten Strahlungsimpulses 25 zeitliche Abstände der Länge von jeweils einer halben Periodendauer T des Taktsignal des Oszillators 21. Zur Illustration dessen sind Digitaldaten des ersten ADC 19 durch ein Kreissymbol und Digitaldaten des zweiten ADC 20 durch ein Dreieck auf der Kurve des reflektierten Strahlungsimpulses 25 angedeutet.

Die Fig. 8 zeigt eine symbolische Darstellung der Digitalwerte bzw. der digitalen Signalvektoren, wie sie auch der in der Fig. 7 beschriebenen Situation der zweiten Betriebsweise des Entfernungsmessers 1 entspricht. Dabei sind in dem tabellarischen Schema in der ersten Zeile die Digitaldaten (z.B. 8 Bit Werte) der Messwerte des ersten Digitalsignalvektors "DSV 1" und in der zweiten Zeile die Digitaldaten der Messwerte des zweiten Digitalsignalvektors "DSV 2" dargestellt. Das zeitlich abwechselnde Aufeinanderfolgen der Werte des ersten Digitalsignalvektors DSV 1 und der Werte des zweiten Digitalsignalvektors DSV 2 ist dabei durch eine seitliche Versetzung zwischen der ersten und der zweiten Zeile in der Fig. 8 angedeutet. Durch die Steuervorrichtung 16 bzw. den FPGA wird schließlich ein gesamter Digitalsignalvektor "DSV" erzeugt, wobei die Werte dieses Digitalsignalvektors DSV durch eine Verschränkung bzw. Verschachtelung der Werte des ersten und des zweiten Digitalsignalvektors DSV 1, DSV 2 gebildet wird. Dieser so erhaltene Digitalsignalvektor DSV entspricht einer Messung des Intensitätsverlaufs des reflektierten Strahlungsimpulses 25 mit einer doppelt so hohen Abtastrate als es der Frequenz des Taktsignals des Oszillators 21 entspricht.

Die oben beschriebene Methode zur Verbesserung des gemessenen Signals durch Aufsummieren vieler Einzelmessungen ist selbstverständlich auch in Kombination mit den zwei neuartigen Betriebsweisen möglich. Und zwar in der Form, dass in einem ersten Schritt die zwei ADC's wie beschrieben in den unterschiedlichen Betriebsweisen betrieben werden und in einem zweiten Schritt die daraus resultierenden einzelnen DSVs (Fig. 6: DSV SUM oder Fig. 8: DSV) wieder zu einem neuen Summensignalvektor aufsummiert werden.

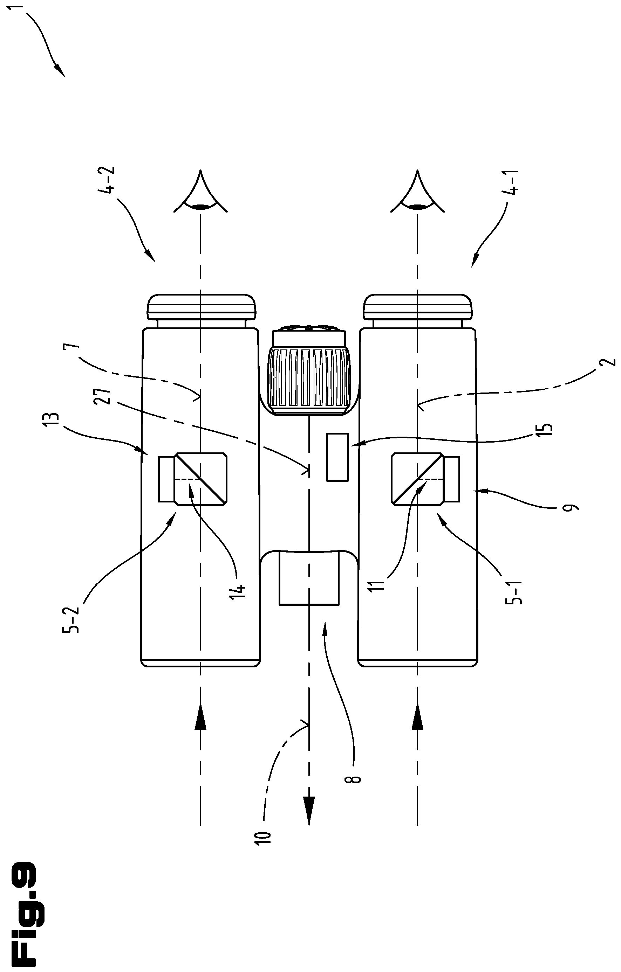

Die Fig. 9 zeigt ein alternatives Ausführungsbeispiel des elektrooptischen Entfernungsmessers 1 in Form eines Binokulars. Dabei verläuft der erste Empfängerstrahlengang 11 des ersten Empfängers 9 zumindest teilweise in dem ersten Beobachtungsstrahlengang 2 des ersten Tubus des Binokulars und analog dazu der zweite Empfängerstrahlengang 14 des zweiten Empfänger 13 zumindest teilweise in dem zweiten Beobachtungsstrahlengang 7 des zweiten Tubus des Binokulars. Gemäß diesem Ausführungsbeispiel ist vorgesehen, dass der Sendestrahlengang 10 des Senders 8 des Entfernungsmessers 1 von den beiden Beobachtungsstrahlengängen 2, 7 distanziert angeordnet ist. Gemäß der Darstellung in Fig. 9 ist der Sender 8 in etwa mittig zwischen den beiden Tuben des Binokulars angeordnet. Vorzugsweise ist der Sender 8 koaxial mit einer Gelenkachse 27 einer Gelenkbrücke des Binokulars angeordnet bzw. ausgerichtet. Durch Strahlenteiler, wie zum Beispiel als Strahlteiler wirkende Grenzflächen der Umkehrsysteme 5-1, 5-2, werden reflektierte Strahlungsimpulse 25 aus den Beobachtungstrahlengängen 2, 7 ausgekoppelt und gelangen zu den Empfängern 9, 13, von denen sie detektiert werden. Messsignale der Empfänger 9, 13 werden schließlich von der Steuer- und Auswerteeinheit 15 weiterverarbeitet. Mit dem Entfernungsmesser 1 gemäß der Ausführungsform der Fig. 9 ist die Durchführung von Messungen in der gleichen Weise, wie vorstehend als erste und zweite Betriebsweise beschrieben, möglich.

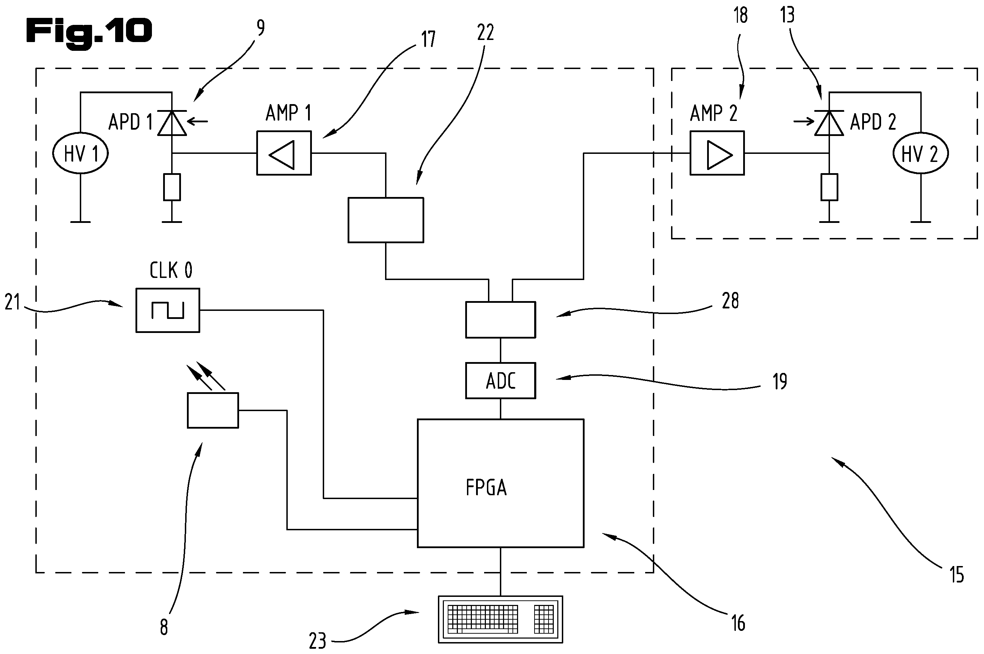

Die Fig. 10 zeigt ein alternatives Ausführungsbeispiel der Steuer- und Auswerteeinheit 15 des Entfernungsmessers 1, dargestellt als vereinfachtes Schaltbild. In gleicher Weise wie bei dem Ausführungsbeispiel, das anhand von Fig. 2 beschrieben worden ist, werden von den Empfängern 9, 13 Intensitätsverläufe der reflektierten Strahlung bzw. reflektierte Strahlungsimpulse 25 detektiert. Gemäß diesem Ausführungsbeispiel des Entfernungsmessers 1 ist vorgesehen, dass die analogen Signale der Empfänger 9, 13 nach Verstärkung (Verstärker 17, 18) durch einen Summierverstärker 28 zu einem Summensignal addiert werden. Dieses analoge Summensignal wird sodann durch den ADC 19 in ein digitales Signal umgewandelt. Bei diesem Ausführungsbeispiel des elektrooptischen Entfernungsmessers ist der Phasenschieber 22 zwischen dem ersten Empfänger 9 bzw. dem ersten Verstärker 17 und dem Summierverstärker 28 angeordnet. Durch die von dem Phasenschieber 22 erzeugte variable Zeit-Differenz Δtᵥ wird somit ebenfalls eine Synchronisierung der von dem ersten Empfänger 9 und dem zweiten Empfänger 13 erhaltenen analogen Messsignale erreicht. Der Phasenschieber 22 umfasst vorzugsweise eine Verzögerungsleitung.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 1: Entfernungsmesser
- 2: Beobachtungsstrahlengang
- 3: Objektiv
- 4: Okular
- 5: Umkehrsystem
- 6: Fokussierlinse
- 7: Beobachtungsstrahlengang
- 8: Sender
- 9: erster Empfänger
- 10: Sendestrahlengang
- 11: erster Empfängerstrahlengang
- 12: Teilerprisma
- 13: zweiter Empfänger
- 14: zweiter Empfängerstrahlengang
- 15: Steuer- und Auswerteeinheit
- 16: Steuervorrichtung
- 17: Verstärker
- 18: Verstärker
- 19: erster ADC
- 20: zweiter ADC
- 21: Oszillator
- 22: Phasenschieber
- 23: Bedienterminal
- 24: Laserpuls
- 25: reflektierter Strahlungsimpuls
- 26: Impulslaufzeit
- 27: Gelenkachse
- 28: Summierverstärker

## Patentansprüche

1. Binokulares Fernrohr mit einem elektrooptischen Entfernungsmesser (1) mit einem ersten und einem dazu distanzierten und annähernd parallelen zweiten Beobachtungsstrahlengang (2, 7)
- mit jeweils einem Okular (4-1, 4-2), einem Prismen-Umkehrsystem (5-1, 5-2), einer Fokussierlinse 6-1, 6-2) und einem Objektiv (3-1, 3-2)
- und mit einem Sender (8) und einem Sendestrahlengang (10) und mit einem ersten Empfänger (9) und einem ersten Empfängerstrahlengang (11),
- wobei der erste Empfängerstrahlengang (11) teilweise in dem ersten Beobachtungsstrahlengang (2) des Fernrohrs bis zu einer Grenzfläche des Prismen-Umkehrsystems (5-1) und teilweise von der Grenzfläche des Prismen-Umkehrsystems (5-1) zu dem ersten Empfänger (9) hin verläuft,
- **dadurch gekennzeichnet, dass** ein zweiter Empfänger (13) mit einem zweiten Empfängerstrahlengang (14) ausgebildet ist,
- wobei der zweite Empfängerstrahlengang (14) teilweise in dem zweiten Beobachtungsstrahlengang (7) des Fernrohrs bis zu einer Grenzfläche des Prismen-Umkehrsystems (5-2) und teilweise von der Grenzfläche des Prismen-Umkehrsystems (5-2) zu dem zweiten Empfänger (13) hin verläuft,
- wobei die Empfänger (9, 13) zur Detektion eines ersten Intensitätsverlaufs IR1(t) und eines zweiten Intensitätsverlaufs IR2(t) ausgebildet sind,
- und dass eine Steuer- und Auswerteeinheit (15) mit einem ersten ADC (19), mit einem zweiten ADC (20), mit einem Oszillator (21) und mit einem Phasenschieber (22) ausgebildet ist,
- wobei die Steuer- und Auswerteeinheit (15) zur Berechnung eines Summenwertes aus von dem ersten ADC (19) und von dem zweiten ADC (20) erzeugten digitalen Werten des ersten Intensitätsverlaufs IR1(t) und des zweiten Intensitätsverlaufs IR2(t) zu von dem Oszillator (21) mit einem Taktsignal bestimmten Zeitpunkten ausgebildet ist,
- und dass der Phasenschieber (22) zur Erzeugung einer variablen Zeit-Differenz Δtᵥ zwischen einem Zeitpunkt t1ₙ einer Aktivierung des ersten ADC (19) und einem Zeitpunkt t2ₙ einer Aktivierung des zweiten ADC (20) und somit zur Kompensation von Unterschieden in den Signallaufzeiten zu den beiden ADC (19, 20) hin und/oder von zeitlichen Verzögerungen ausgebildet ist,
- oder dass eine Steuer- und Auswerteeinheit (15), mit einem Summierverstärker (28), mit einem ADC (19), mit einem Oszillator (21) und mit einem Phasenschieber (22) ausgebildet ist,
- wobei der Summierverstärker (28) zur Addition des ersten Intensitätsverlaufs IR1(t) und des zweiten Intensitätsverlaufs IR2(t) zu einem Summensignal ausgebildet ist,
- und wobei der ADC (19) zur Erzeugung von digitalen Werten aus dem Summensignal zu von dem Oszillator (21) mit einem Taktsignal bestimmten Zeitpunkten ausgebildet ist,
- und dass der Phasenschieber (22) zwischen dem ersten Empfänger (9) und dem Summierverstärker (28) angeordnet und zur Erzeugung einer variablen Zeit-Differenz Δtᵥ zur Synchronisation des ersten Intensitätsverlaufs IR1(t) und des zweiten Intensitätsverlaufs IR2(t) ausgebildet ist.

2. Fernrohr nach Anspruch 1, **dadurch gekennzeichnet, dass** der Sendestrahlengang (10) zumindest teilweise in dem ersten Beobachtungsstrahlengang (2) des Fernrohrs verläuft.

3. Fernrohr nach Anspruch 1 oder 2, **dadurch gekennzeichnet, dass** der Phasenschieber (22) eine Phasenregelschleife, Phase-Locked Loop, PLL, umfasst.

4. Fernrohr nach einem der vorhergehenden Ansprüche, **dadurch gekennzeichnet, dass** der Phasenschieber (22) eine Verzögerungsleitung mit einer definierten Leitungslänge umfasst.

5. Fernrohr nach einem der vorhergehenden Ansprüche, **dadurch gekennzeichnet, dass** in dem Entfernungsmesser (1) eine Steuervorrichtung (16) mit einem Prozessor, insbesondere mit einem FPGA, Field Programmable Gate Array, ausgebildet ist.

6. Fernrohr (1) nach Anspruch 5, **dadurch gekennzeichnet, dass** in dem Entfernungsmesser (1) eine erste Betriebsweise, bei der die digitalen Werte der detektierten Strahlungsintensitäten der beiden Empfänger (9, 13) synchronisiert zu einem Summenwert addiert werden, und eine zweite Betriebsweise, bei der die Abtastung der reflektierten Strahlungsintensität durch die beiden Empfänger (9, 13) abwechselnd, um eine halbe Periodendauer T phasenverschoben erfolgt, ausgebildet sind.

7. Fernrohr (1) nach Anspruch 6, **dadurch gekennzeichnet, dass** ein mit der Steuervorrichtung (16) in Verbindung stehendes Bedienterminal (23) ausgebildet ist, wobei das Bedienterminal (23) zur Auswahl der unterschiedlichen Betriebsweisen geeignet ist.

## Claims

1. A binocular with an electro-optical rangefinder (1) having a first observation beam path (2, 7) and a second observation beam path (2, 7) arranged at distance therefrom and approximately parallel thereto,
- each having an eyepiece (4-1, 4-2), a prism erecting system (5-1, 5-2), a focusing lens (6-1, 6-2) and an objective lens (3-1, 3-2)
- and having a transmitter (8) and a transmission beam path (10) and having a first receiver (9) and a first receiver beam path (11),
- wherein the first receiver beam path (11) extends partially in the first observation beam path (2) of the binocular up to a boundary surface of the prism erecting system (5-1) and partially from the boundary surface of the prism erecting system (5-1) to the first receiver (9),
- **characterized in that** a second receiver (13) with a second receiver beam path (14) is formed,
- wherein the second receiver beam path (14) extends partially in the second observation beam path (7) of the binocular up to a boundary surface of the prism erecting system (5-2) and partially from the boundary surface of the prism erecting system (5-2) to the second receiver (13),
- wherein the receivers (9, 13) are configured to detect a first intensity course IR1(t) and a second intensity course IR2(t),
- and that a control and evaluation unit (15) with a first ADC (19), with a second ADC (20), with an oscillator (21) and with a phase shifter (22) is formed,
- wherein the control and evaluation unit (15) is configured to calculate a summed value from digital values of the first intensity course IR1(t) and of the second intensity course IR2(t) generated by the first ADC (19) and by the second ADC (20) at points in time determined by the oscillator (21) with a clock signal,
- and that the phase shifter (22) is configured to generate a variable time difference Δtᵥ between a time t1ₙ of activation of the first ADC (19) and a time t2ₙ of activation of the second ADC (20) and thus to compensate for differences in the signal propagation times to the two ADCs (19, 20) and/or for time delays,
- or that a control and evaluation unit (15) with a summing amplifier (28), with an ADC (19), with an oscillator (21) and with a phase shifter (22) is formed,
- wherein the summing amplifier (28) is configured to add the first intensity course IR1(t) and the second intensity course IR2(t) to form a sum signal,
- and wherein the ADC (19) is configured to generate digital values from the sum signal at points in time determined by the oscillator (21) with a clock signal,
- and that the phase shifter (22) is arranged between the first receiver (9) and the summing amplifier (28) and is configured to generate a variable time difference Δtᵥ for synchronizing the first intensity course IR1(t) and the second intensity course IR2(t).

2. The binocular according to claim 1, **characterized in that** the transmission beam path (10) extends at least partially in the first observation beam path (2) of the binocular.

3. The binocular according to claim 1 or 2, **characterized in that** the phase shifter (22) comprises a phase-locked loop, PLL.

4. The binocular according to one of the preceding claims, **characterized in that** the phase shifter (22) comprises a delay line with a defined line length.

5. The binocular according to one of the preceding claims, **characterized in that** a controller (16) having a processor, in particular having an FPGA, field programmable gate array, is formed in the rangefinder (1).

6. The binocular according to claim 5, **characterized in that** a first operating mode, in which the digital values of the detected radiation intensities of the two receivers (9, 13) are added to a summed value in a synchronized manner, and a second operating mode, in which sampling of the reflected radiation intensity by the two receivers (9, 13) is performed alternately shifted in phase by half a period T, are provided in the rangefinder (1).

7. The binocular according to claim 6, **characterized in that** an operator terminal (23) connected to the controller (16) is provided, wherein the operator terminal (23) is suitable for selecting different operating modes.

## Revendications

1. Lunette de visée binoculaire avec un télémètre électro-optique (1) comprenant un premier et un deuxième chemins optiques d'observation (2, 7) espacés et approximativement parallèles l'un à l'autre
- chacun avec un oculaire (4-1, 4-2), un invertoscope (5-1, 5-2), une lentille de mise au point (6-1, 6-2) et un objectif (3-1, 3-2)
- et avec un émetteur (8) et un chemin optique d'émission (10) et avec un premier récepteur (9) et un premier chemin optique de réception (11),
- le premier chemin optique de réception (11) s'étendant en partie dans le premier chemin optique d'observation (2) de la lunette de visée jusqu'à une surface limite de l'invertoscope (5-1) et en partie depuis la surface limite de l'invertoscope (5-1) vers le premier récepteur (9),
- **caractérisé en ce qu'**un deuxième récepteur (13) est formé avec un deuxième chemin optique de réception (14),
- le deuxième chemin optique de réception (14) s'étendant en partie dans le deuxième chemin optique d'observation (7) de la lunette de visée jusqu'à une surface limite de l'invertoscope (5-2) et en partie depuis la surface limite de l'invertoscope (5-2) vers le deuxième récepteur (13),
- les récepteurs (9, 13) étant conçus pour détecter une première courbe d'intensité IR1(t) et une deuxième courbe d'intensité IR2(t),
- et une unité de commande et d'évaluation (15) étant formée avec un premier CAN (19), avec un deuxième CAN (20), avec un oscillateur (21) et avec un déphaseur (22),
- l'unité de commande et d'évaluation (15) étant conçue pour calculer une valeur totale à partir des valeurs numériques générées par le premier CAN (19) et le deuxième CAN (20) de la première courbe d'intensité IR1(t) et de la deuxième courbe d'intensité IR2(t) à des moments déterminés par l'oscillateur (21) à l'aide d'un signal d'horloge.
- et **en ce que** le déphaseur (22) est conçu pour générer une différence temporelle variable Δtᵥ entre un instant t1ₙ d'une activation du premier CAN (19) et un instant t2ₙ d'une activation du deuxième CAN (20) et ainsi pour compenser des différences dans les temps de propagation des signaux vers les deux CAN (19, 20) et/ou des retards temporels,
- ou **en ce qu'**une unité de commande et d'évaluation (15) est formée avec un amplificateur de sommation (28), avec un CAN (19), avec un oscillateur (21) et avec un déphaseur (22),
- l'amplificateur de sommation (28) étant conçu pour additionner la première courbe d'intensité IR1(t) et la deuxième courbe d'intensité IR2(t) afin d'obtenir un signal de somme,
- et le CAN (19) étant conçu pour générer des valeurs numériques à partir du signal de somme à des moments déterminés par l'oscillateur (21) à l'aide d'un signal d'horloge,
- et **en ce que** le déphaseur (22) est agencé entre le premier récepteur (9) et l'amplificateur de sommation (28) et est conçu pour générer une différence temporelle variable Δtᵥ afin de synchroniser la première courbe d'intensité IR1(t) et la deuxième courbe d'intensité IR2(t).

2. Lunette de visée selon la revendication 1, **caractérisée en ce que** le trajet du chemin optique (10) s'étend au moins en partie dans le premier trajet du chemin optique d'observation (2) de la lunette de visée.

3. Lunette de visée selon la revendication 1 ou 2, **caractérisée en ce que** le déphaseur (22) comprend une boucle à verrouillage de phase, Phase-Locked Loop, PLL.

4. Lunette de visée selon l'une des revendications précédentes, **caractérisée en ce que** le déphaseur (22) comprend une ligne de retard avec une longueur de ligne définie.

5. Lunette de visée selon l'une des revendications précédentes, **caractérisée en ce qu'**un dispositif de commande (16) avec un processeur, en particulier avec un FPGA, Field Programmable Gate Array, est formé dans le télémètre (1).

6. Lunette de visée selon la revendication 5, **caractérisée en ce que** le télémètre (1) comprend un premier mode de fonctionnement dans lequel les valeurs numériques des intensités de rayonnement détectées par les deux récepteurs (9, 13) sont synchronisées et additionnées pour obtenir une valeur totale, et un deuxième mode de fonctionnement dans lequel le balayage de l'intensité de rayonnement réfléchie par les deux récepteurs (9, 13) est décalé d'une demi-période T.

7. Lunette de visée selon la revendication 6, **caractérisée en ce qu'**un terminal de commande (23) relié au dispositif de commande (16) est formé, le terminal de commande (23) étant adapté pour sélectionner les différents modes de fonctionnement.
